# EUROPÄISCHE PATENTSCHRIFT

(11) **EP 2 891 030 B1**
(45) Veröffentlichungstag und Bekanntmachung des Hinweises auf die Patenterteilung: **26.12.2018**
(21) Anmeldenummer: 13745803.0
(22) Anmeldetag: 18.07.2013
(51) Int. Cl.: G06F 1/28, G06F 1/32, G01R 31/40, G01R 21/00

(54) **BESTIMMUNG EINES ERSATZWERTS FÜR DIE PRIMÄRSEITIGE LEISTUNGSAUFNAHME EINES NETZTEILS**
DETERMINING A SUBSTITUTE VALUE FOR THE PRIMARY SIDE POWER CONSUMPTION OF A POWER ADAPTER
DÉTERMINATION D'UNE VALEUR DE SUBSTITUTION POUR LA CONSOMMATION DE PUISSANCE AU PRIMAIRE D'UNE ALIMENTATION

(30) Priorität: 28.08.2012 DE 102012107916
(43) Veröffentlichungstag der Anmeldung: 08.07.2015
(73) Patentinhaber: Fujitsu Limited, Kawasaki-shi Kanagawa 211-8588 (JP)
(72) Erfinder: CLEMENS, Martin, 33106 Paderborn (DE)
(74) Vertreter: Epping - Hermann - Fischer
(86) Internationale Anmeldenummer: PCT/EP2013/065210
(87) Internationale Veröffentlichungsnummer: WO 2014/032853

(56) Entgegenhaltungen:
- JP-A- 2011 086 174
- US-A1- 2008 320 322
- US-A1- 2009 306 914

## Beschreibung

Die Erfindung betrifft ein Verfahren zur Bestimmung eines Ersatzwerts einer primärseitigen Leistungsaufnahme eines Netzteils. Die Erfindung betrifft des Weiteren ein zum Ausführen eines Verfahrens zur Bestimmung eines Ersatzwerts einer primärseitigen Leistungsaufnahme eines Netzteils eingerichtetes Computersystem, sowie ein Computerprogrammprodukt.

Üblicherweise werden Computersysteme durch ein Stromnetz versorgt, welches eine Wechselspannung zur Verfügung stellt. Allgemein bekannt sind Verfahren, welche zum Bestimmen der Leistungsaufnahme des Computersystems die Leistungsaufnahme eines Netzteils auf der Primärseite des Netzteils bestimmen.

Problematisch an einem derartigen Ansatz ist es, dass die Versorgungsspannung eine Wechselspannung ist. Hierdurch kann die Leistungsaufnahme nicht einfach durch Multiplikation von Strom und Spannung bestimmt werden, sondern es müssen Integrationsverfahren verwendet werden. Diese Verfahren müssen über einen bestimmten Zeitraum hinweg integrieren, so dass dem Computersystem nur in relativ großen Zeitabständen Daten zur primärseitigen Leistungsaufnahme des Computersystems übermittelt werden können.

Prozessoren eines Computersystems können gedrosselt werden, falls festgestellt wird, dass die Leistungsaufnahme des Computersystems einen gewissen Grenzwert übersteigt. Die Betriebssicherheit des Computersystems wird größer, je schneller das Computersystem auf Schwankungen in der Leistungsaufnahme des Computersystems reagieren kann.

Aus der US 2008/0320322 A1 ist eine dynamische Leistungsverbrauchsverwaltung für ein Computersystem mit wenigstens zwei parallelen Leistungswandlern bekannt. Hierbei wird eine maximale Leistungskapazität für jeden Leistungswandler bestimmt und anschließend der Leistungsverbrauch des Computersystems überwacht. Kann die Leistungsaufnahme des Computersystems durch weniger als alle parallelen Leistungswandler bedient werden, werden einer oder mehrere Leistungswandler abgeschaltet, sodass eine reduzierte Anzahl Leistungswandler angeschaltet bleibt. Eine reduzierte maximale Leistungskapazität wird bestimmt und eine Leistungsgrenze wird für das Computersystem gesetzt die geringer oder gleich der reduzierten Leistungskapazität ist. Das Computersystem wird an der Leistungsgrenze gedrosselt, um zu verhindern, dass der Leistungsverbrauch die Leistungsgrenze übersteigt.

Aufgabe der vorliegenden Erfindung ist es, ein verbessertes Verfahren zum Bestimmen der primärseitigen Leistungsaufnahme eines Netzteils zu beschreiben, das insbesondere schneller oder einfacher arbeitet als bekannte Integrationsverfahren.

Gemäß einem ersten Aspekt der Erfindung wird ein Verfahren für ein Computersystem beschrieben, welches sich zum Bestimmen eines Ersatzwerts für die primärseitige Leistungsaufnahme des Netzteils des Computersystems Messwerte der sekundärseitigen Ausgangsleistung des Netzteils und den Wirkungsgrad des Netzteils zunutze macht. Die Schritte des Verfahrens umfassen hierbei:
- Wiederholtes Erfassen eines ersten Messwerts bezüglich einer primärseitigen Leistungsaufnahme über jeweils einen Messzeitraum;
- wiederholtes Erfassen eines zweiten Messwerts bezüglich wenigstens einer sekundärseitigen Ausgangsleistung in ersten zeitlichen Abständen, wobei der erste zeitliche Abstand kleiner ist als der Messzeitraum;
- Ermitteln eines Wirkungsgrads des Netzteils basierend auf dem ersten Messwert und wenigstens einem zweiten Messwert für jeweils einen Messzeitraum; und
- Errechnen eines Ersatzwerts für die primärseitige Leistungsaufnahme basierend auf dem im Schritt des Ermittelns ermittelten Wirkungsgrad und wenigstens einem erfassten zweiten Messwert.

Beim Erfassen eines ersten Messwerts wird die Leistungsaufnahme auf der netzseitigen Seite des Netzteils, beispielsweise durch Integrieren, über einen gewissen Zeitraum ermittelt. In typischerweise deutlich kleineren Zeitabständen wird auf der Sekundärseite des Netzteils die Ausgangsleistung des Netzteils bestimmt. Dies ist möglich, da das Netzteil in der Regel eine Gleichspannung ausgibt, welche einfach gemessen und beispielsweise durch Multiplizieren mit dem Ausgangsstrom zur Bestimmung einer Ausgangsleistung genutzt werden kann. Aus dem primärseitig erfassten ersten Messwert und wenigstens einem sekundärseitig erfassten zweiten Messwert kann nun ein Wirkungsgrad für das Netzteil bestimmt werden, welcher in guter Näherung für den aktuellen und einen oder mehrere nachfolgende Messzeiträume zur Bestimmung des ersten Messwerts Gültigkeit besitzt. Mit Hilfe dieses Wirkungsgrads des Netzteils kann nun, beispielsweise in einem nächsten Messzeitraum, zu jedem Zeitpunkt, zu dem ein Wert der sekundärseitigen Ausgangsleistung zur Verfügung steht, ein Ersatzwert für die primärseitige Leistungsaufnahme des Netzteils errechnet werden.

Ein Vorteil dieses Verfahrens ist es, dass Werte für die Leistungsaufnahme des Netzteils während einer nachfolgenden Integrationsphase zur Bestimmung der primärseitigen Leistungsaufnahme des Netzteils häufiger zur Verfügung stehen, als dies unter Berücksichtigung lediglich der primärseitigen ersten Messwerte möglich wäre.

Gemäß einer vorteilhaften Ausführung des Verfahrens wird der Wirkungsgrad aus wenigstens einem primärseitigen ersten Messwert und einem Mittelwert einer Mehrzahl sekundärseitiger zweiter Messwerte ermittelt. Durch das Ermitteln eines Mittelwerts des Wirkungsgrads aus einem Mittelwert einer Mehrzahl sekundärseitiger zweiter Messwerte und wenigstens einem primärseitigen ersten Messwert können exaktere Werte für den Wirkungsgrad ermittelt werden. Ebenso ist es möglich, einen Mittelwert des Wirkungsgrads des Netzteils zu ermitteln, indem eine Mehrzahl an Werten für den Wirkungsgrad ermittelt wird und erst hiernach ein Mittelwert aus den einzelnen Werten für den Wirkungsgrad ermittelt wird.

Gemäß einer vorteilhaften Ausführung des Verfahrens werden die Mittelwerte des Wirkungsgrads des Netzteils ein weiteres Mal gemittelt. Hierbei wird ein Zeitraum, der einem Vielfachen des Messzeitraums entspricht, berücksichtigt. Ein Vorteil hierbei ist, dass eine nochmals stabilere Vorhersage der Werte möglich ist.

Gemäß einer weiteren vorteilhaften Ausführung des Verfahrens wird der Schritt des Errechnens der Ersatzwerte für die primärseitige Leistungsaufnahme des Netzteils periodisch in zeitlichen Abständen ausgeführt, wobei der zeitliche Abstand kleiner ist als der Messzeitraum. Durch diese Variante des Verfahrens ist es möglich, Werte bezüglich der primärseitigen Leistungsaufnahme dem Computersystem häufig zur Verfügung zu stellen.

Gemäß einer weiteren vorteilhaften Ausführung des Verfahrens werden zur Ermittlung des Wirkungsgrads des Netzteils nicht nur die primär- und sekundärseitigen Leistungen berücksichtigt, sondern unter anderem auch die Eingangsspannung, die durch die Lüfterdrehzahl bestimmte Leistungsaufnahme eines im Netzteil vorhandenen Lüfters und der Lastbereich des Netzteils. Die Eingangsspannung kann verschiedene Werte aufweisen, die Lüfterdrehzahl und der Lastbereich des Netzteils können schwanken und haben einen Einfluss auf den Wirkungsgrad des Netzteils. Durch diese Verfeinerung des Verfahrens können präzisere Ersatzwerte zur Verfügung gestellt werden.

Ein weiterer Aspekt der Erfindung umfasst ein Computersystem, welches ein Netzteil und einen Mikrocontroller umfasst, wobei der Mikrocontroller dazu eingerichtet ist, Messwerte bezüglich der wenigstens einen sekundärseitigen Ausgangsleistung des Netzteils in kürzeren zeitlichen Abständen als die primärseitigen Messwerte zu erfassen. Der Mikrocontroller ermittelt aus mindestens diesen Messwerten und den Werten der primärseitigen Leistungsaufnahme den Wirkungsgrad des Netzteils und errechnet dann aus den Messwerten der wenigstens einen sekundärseitigen Ausgangsleistung des Netzteils und dem Wirkungsgrad einen Ersatzwert für die primärseitige Leistungsaufnahme des Netzteils. Ein solches Computersystem ist insofern vorteilhaft, dass es Ersatzwerte zur primärseitigen Leistungsaufnahme in deutlich kürzeren zeitlichen Abständen als herkömmliche Computersysteme ermittelt.

Gemäß einer vorteilhaften Ausführung ist der Mikrocontroller im Netzteil des Computersystems angeordnet. Beispielsweise ist es möglich, einen bereits vorhandenen Mikrocontroller zu verwenden und auf den Mehraufwand durch den Einbau eines gesonderten Mikrocontrollers zu verzichten.

Gemäß einer weiteren vorteilhaften Ausführung ist der Mikrocontroller Teil einer Systemmanagementkomponente, welcher auf einer Hauptplatine angeordnet ist. Diese Ausführung hat den Vorteil, dass ein bereits zum Management des Computersystems vorgesehener Mikrocontroller verwendet werden kann, der die Leistungen des Prozessors regelt und somit die Leistungsaufnahme des gesamten Computersystems begrenzt.

Gemäß einer weiteren vorteilhaften Ausführung ist der Mikrocontroller Teil eines Chipsatzes des Computersystems. Durch die Verwendung eines Mikrocontrollers des in der Regel ohnehin vorhandenen Chipsatzes des Computersystems kann man auf den Einbau zusätzlicher Komponenten verzichten.

Unterschiedliche Ausführungsbeispiele werden nachfolgend in Bezugnahme auf die angehängten Figuren beschrieben. Hierbei zeigen:
- Figur 1: ein Computersystem gemäß einer Ausgestaltung der Erfindung,
- Figur 2: ein Ablaufdiagramm eines Verfahrens gemäß einer Ausgestaltung der Erfindung, und
- Figur 3: Graphen, aufzeigend fünf verschiedene Größen.

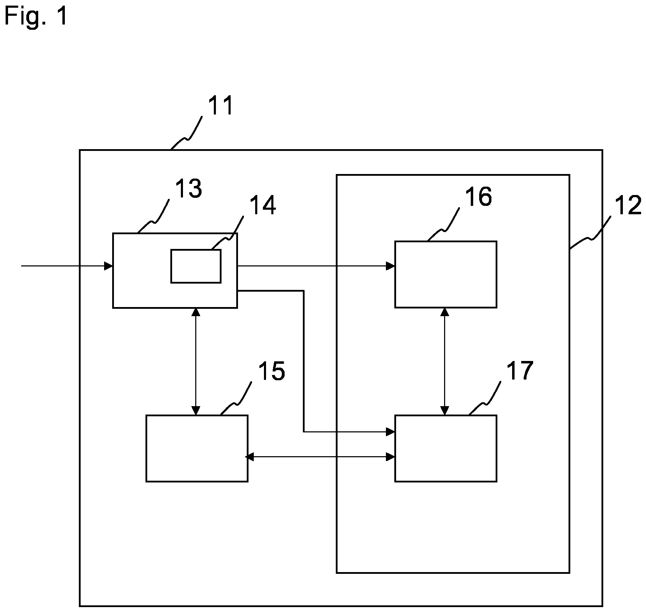

Figur 1 zeigt ein Blockdiagramm eines Computersystems 11, in dem eine Systemkomponente 12, insbesondere eine Hauptplatine angeordnet ist, welche durch ein Netzteil 13 mit verschiedenen Betriebsspannungen unter anderem für einzelne Komponenten der Systemkomponente 12 versorgt wird. Mögliche Komponenten der Systemkomponente 12 sind beispielsweise ein Prozessor 16 oder eine Systemmanagementkomponente 17. Das Netzteil 13 nimmt eine Netzwechselspannung zur Versorgung des Computersystems 11 primärseitig auf und gibt auf der Sekundärseite eine oder mehrere verschiedene sekundäre Gleichspannungen wieder ab. Um eine Überhitzung des Netzteils 13 zu vermeiden, ist im Netzteil 13 im Ausführungsbeispiel ein Lüfter 14 angeordnet.

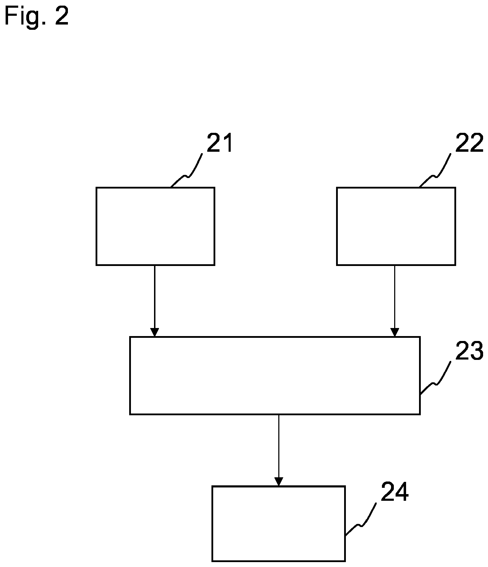

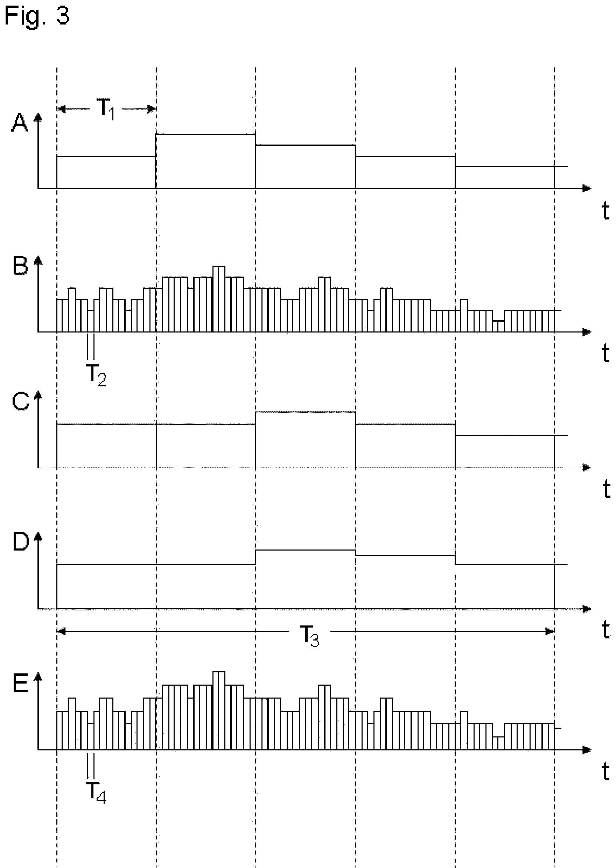

Das Computersystem 11 weist des Weiteren einen Mikrocontroller 15 auf. Der Mikrocontroller 15 ist dazu eingerichtet, die relevanten sekundärseitigen Ausgangsleistungen des Netzteils 13 zu bestimmen. Darüber hinaus errechnet der Mikrocontroller 15 einen Wirkungsgrad des Netzteils 13. Aus diesen Werten kann der Mikrocontroller 15 wie weiter unter Bezugnahme auf die Figuren 2 und 3 erläutert, im Anschluss dann in sehr kurzen zeitlichen Abständen Werte für die primärseitige Leistungsaufnahme des Computersystems 11 errechnen.

Gemäß der beschriebenen Ausgestaltung ist das Computersystem 11 dazu eingerichtet, dass der Mikrocontroller 15 die errechneten Ersatzwerte der primärseitigen Leistungsaufnahme des Netzteils 13 an die Systemmanagementkomponente 17 weiterleitet. Die Systemmanagementkomponente 17 kann mit den erhaltenen Informationen des Mikrocontrollers 15 das Computersystem 11 derart beeinflussen, dass es die Leistungsaufnahme des Prozessors 16 reduziert, was eine Reduzierung der primärseitigen Leistungsaufnahme des Netzteils 13 zur Folge hat.

Gemäß einer vorteilhaften nicht dargestellten Ausgestaltung ist der Mikrocontroller 15 Teil der Systemmanagementkomponente 17. Diese Systemmanagementkomponente 17 kann auf der Hauptplatine angeordnet sein. Die Systemmanagementkomponente 17 kann als Systemmanagementbaustein (englisch: Baseboard Management Controller, BMC) ausgeführt sein, der unter Anderem einen Mikrocontroller umfasst und dazu eingerichtet ist, Fernwartefunktionen über eine Netzwerkschnittstelle bereitzustellen und über einen Systemmanagementbus unter anderem Einfluss auf Hardwarekomponenten, zum Beispiel einen Prozessor zu nehmen. So kann der BMC unter anderem die Prozessorleistung steuern und somit die Leistungsaufnahme des Prozessors verändern. Dies kann beispielsweise durch Anlegen eines sogenannten PROCHOT# Signals geschehen, welches einen prozessorinternen Stromsparmodus initiiert.

Gemäß einer vorteilhaften nicht dargestellten Ausgestaltung kann der zur Bestimmung der Leistungsaufnahme verwendete Mikrocontroller auch in dem Netzteil 13 des Computersystems 11 angeordnet sein. Der Vorteil einer derartigen Anordnung ist, dass ein Mikrocontroller, der bereits im Netzteil 13 verbaut ist und beispielsweise der Regelung eines darin verbauten Schaltwandlers dient, zum Zwecke des Ausführens des Verfahrens entsprechend der Erfindung genutzt werden kann.

Gemäß einer weiteren vorteilhaften, nicht dargestellten Ausführung ist es auch möglich, dass der Mikrocontroller 15 Teil eines Chipsatzes des Computersystems 11.

Figur 2 zeigt ein mögliches Ablaufdiagramm eines Verfahrens zur Bestimmung eines Ersatzwerts einer primärseitigen Leistungsaufnahme des Netzteils 13.

In einem ersten Schritt 21 wird die primärseitige Leistungsaufnahme des Netzteils 13 gemessen. Da es sich um eine Netzwechselspannung handelt, erfolgt die Bestimmung der Leistungsaufnahme der Stromversorgung nicht einfach durch Multiplikation von Spannung und Strom, sondern beispielsweise durch Verwendung eines an sich bekannten Integrationsverfahrens. Dieses Verfahren benötigt einen verhältnismäßig langen Zeitraum. So steht dem Computersystem 11 beispielsweise lediglich jede Sekunde ein neuer Messwert der primärseitigen Leistungsaufnahme zur Verfügung. Dies ist insofern unbefriedigend, da das Computersystem 11 teilweise deutlich schneller auf hohe Leistungsspitzen reagieren muss.

Unabhängig davon wird in Schritt 22 schneller die sekundärseitige Ausgangsleistung des Netzteils 13 gemessen. Da das Netzteil 13 einen Gleichstrom bzw. eine Gleichspannung zur Verfügung stellt, ist es hier möglich, die Leistung einfach als Produkt von Strom und Spannung zu ermitteln. Dies erfolgt in wesentlich kürzeren zeitlichen Abständen als es in Schritt 21 möglich ist, die Messwerte zur Verfügung zu stellen, beispielsweise alle 0,05 Sekunden.

In Schritt 23 wird ein Wirkungsgrad des Netzteils 13 ermittelt. Hierfür der wenigstens eine erfasste Messwert aus Schritt 22 in Relation zu dem wenigstens einen Messwert aus Schritt 21 gesetzt.

Mit Hilfe dieses Wirkungsgrads kann nun in Schritt 24 für jeden weiteren Wert der sekundären Ausgangsleistung ein Ersatzwert für die primärseitige Leistungsaufnahme des Netzteils 13 ermittelt werden. Da sich der Wirkungsgrad des Netzteils 13 langsamer ändert als die Leistungsaufnahme des Computersystems 11, können dem Computersystem 11 schneller und in kürzeren Zeitabständen Werte bezüglich der primärseitigen Leistungsaufnahme zur Verfügung gestellt werden.

Gemäß einer vorteilhaften Ausführung der Erfindung wird zur Berechnung der primärseitigen Leistungsaufnahme nicht nur ein Wert für den Wirkungsgrad, sondern ein Mittelwert des Wirkungsgrads verwendet. Hierfür werden eine Auswahl oder alle erfassten, zu dem wenigstens einen, in Schritt 21 gemessenen Messwert zeitlich korrelierten Messwerte aus Schritt 22, beispielsweise aus demselben Messzeitraum, in Relation zu dem wenigstens einen Messwert aus Schritt 21 gesetzt.

Durch das Bilden eines Mittelwerts der verschiedenen Werte des Wirkungsgrads, beziehungsweise durch das Bilden eines Mittelwerts der verschiedenen in Schritt 22 erfassten Messwerte und anschließendem Bilden des Wirkungsgrads, ist es möglich, genauere Werte für den Wirkungsgrad zu ermitteln.

Gemäß einer vorteilhaften Ausführung der Erfindung wird zur Berechnung der primärseitigen Leistungsaufnahme nicht nur ein Mittelwert des Wirkungsgrads über einen Messzeitraum verwendet, sondern es wird der Wirkungsgrad über einen längeren Zeitraum, zum Beispiel fünf Messzeiträume aus den einzelnen Mittelwerten über je einen einzelnen Messzeitraum gebildet.

Durch das Bilden eines Mittelwerts der verschiedenen vorangegangenen Mittelwerte kann die Genauigkeit des Verfahrens weiter erhöht werden, da kurzzeitige Leistungsschwankungen einen geringeren Einfluss haben. Dies ist insofern von Bedeutung, als dass die dem Computersystem 11 bereitgestellten Messwerte der primärseitigen Leistungsaufnahme in längeren zeitlichen Abständen zur Verfügung gestellt werden können, als die eigentliche Messung, durch beispielsweise ein Integrationsverfahren dauert. Hierdurch sind die Messwerte unter Umständen nicht repräsentativ für diesen Messzeitraum, da sie in einem nicht genau bestimmten Zeitraum innerhalb des Messzeitraums aufgenommen wurden.

Gemäß einer vorteilhaften Ausgestaltung des Verfahrens werden in Schritt 23 des Ermittelns des Wirkungsgrads des Netzteils 13 nicht nur die in Schritt 21 ermittelten Messwerte bezüglich der primärseitigen Leistungsaufnahme und die in Schritt 22 ermittelten Messwerte bezüglich der sekundärseitigen Ausgangsleistung des Netzteils 13 verwendet, sondern es wird auf eine weitere Anzahl an Faktoren, die sich auf den Wirkungsgrad des Netzteils 13 auswirken können, Rücksicht genommen.

Der Wirkungsgrad von Netzteilen hängt unter anderem von deren Lastbereich ab. So ist zu erwarten, dass ein Netzteil besonders günstig in einem Lastbereich zwischen 50% und 90% der maximalen Ausgangsleistung betrieben werden kann. Die Charakteristiken von Netzteilen sind bekannt und können so bei der Berechnung eines Verfahrens gemäß der Erfindung berücksichtigt werden.

Die primärseitige Eingangsspannung kann je nach der Region, in der das Computersystem 11 betrieben wird, unterschiedliche Werte haben. Beispielsweise sind Netzspannungen von 120V oder 235V üblich. Ein Verfahren gemäß einer Ausgestaltung der Erfindung berücksichtigt bei der Berechnung des Wirkungsgrads des Netzteils 13 die primärseitige Eingangsspannung und kann so verbesserte Ersatzwerte für die primärseitige Leistungsaufnahme des Netzteils 13 liefern.

Gemäß der beschriebenen Ausgestaltung des Computersystems 11 ist in das Netzteil 13 ein Lüfter 14 als interner Stromverbraucher integriert. Die Leistungsaufnahme des Lüfters 14 variiert abhängig von dessen Drehzahl. Die Drehzahl des Lüfters 14 hängt von der Temperatur ab. Da sich die Temperatur nicht abrupt ändert, ist nicht zu erwarten, dass sich die Leistungsaufnahme des Lüfters 14 abrupt ändert. Somit können Änderungen in der Leistungsaufnahme des Lüfters 14 in den Werten des Wirkungsgrads des Netzteils 13 mit dem Verfahren gemäß der Erfindung berücksichtigt werden.

Das Netzteil 13 stellt verschiedenen Komponenten des Computersystems 11 unterschiedlich große Betriebsleistungen zur Verfügung. Vorteilhaft für die Berechnung der gesamten sekundären Ausgangsleistung des Netzteils 13 ist das Messen des Teils der Betriebsleistungen, welche häufigen Änderungen unterworfen sind. Erhaltungsspannungen, welche Komponenten wie zum Beispiel diejenigen für das Systemmanagement versorgen, brauchen bei der Erfassung der sekundären Ausgangsleistung beispielsweise nicht gemessen zu werden, da sie sehr gleichmäßige, geringe oder bekannte Werte aufweisen.

Figur 3 zeigt den zeitlichen Verlauf fünf verschiedener Größen. Graph A zeigt die mit einem Integrationsverfahren gemäß Schritt 21 ermittelten Werte für die primärseitige Leistungsaufnahme des Netzteils 13. Diese Werte ändern sich lediglich einmal pro Messzeitraum T₁.

Graph B zeigt die dazu zeitlich korrelierte, in Schritt 22 erfasste sekundärseitig gemessene Leistungsabgabe des Netzteils 13. Diese Werte werden in kürzeren zeitlichen Abständen T₂ ermittelt.

In Graph C ist der bestimmte Wirkungsgrad des Netzteils 13 in Abhängigkeit der beiden in den Graphen A und B dargestellten Größen dargestellt. Es ist ersichtlich, dass die Wirkungsgradwerte jeweils für einen Messzeitraum T₁ wie in Graph A dargestellt bestimmt werden.

Graph D zeigt gemäß einer vorteilhaften Ausgestaltung der Erfindung einen Mittelwert des Wirkungsgrads des Netzteils 13, welcher über einen längeren Zeitraum T₃, beispielsweise den fünf letzten entsprechend Graph C dargestellten Mittelwerten, gebildet wird. Eine Neuberechnung des Mittelwerts findet jeweils mit einem neuen primärseitigen Messwert (Graph A) statt.

In Graph E ist ein bestimmter Ersatzwert für die primärseitige Leistungsaufnahme des Netzteils 13 dargestellt. Der Ersatzwert wird mit Hilfe des Wirkungsgrads des Netzteils 13 und den gemessenen Werten der sekundären Leistungsabgabe errechnet. Durch das Zusammenwirken des Wirkungsgrads und der im Vergleich zu den primärseitig gemessenen ersten Messwerten häufigeren Anzahl an sekundärseitig gemessenen zweiten Messwerten ist es möglich, wie in Graph E dargestellt, nach jeweils einem Zeitraum T₄ einen Ersatzwert für die primärseitige Leistungsaufnahme des Netzteils 13 bereitzustellen. In Graph E ist der Zeitraum T₄ mit dem Zeitraum T₂ identisch. Selbstverständlich können die Zeiträume T₂ und T₄ ebenso unterschiedlich sein.

Durch die Erhöhung der Frequenz der ausgegebenen Ersatzwerte gegenüber dem primären Messzeitraum T₁ kann die Regelgenauigkeit eines nachgeschalteten Algorithmus zur Berechnung der Leistungsaufnahme eines Computersystems bei im Wesentlichen gleichen Messaufwand erhöht werden. Umgekehrt kann eine vorgegebene Regelgenauigkeit bei gleichzeitiger Verfeinerung der Messung beibehalten werden.

Die verschiedenen oben genannten Merkmale können in vielfältiger Weise kombiniert werden, um die jeweils genannten Vorteile zu erreichen.

### Bezugszeichenliste

- 11: Computersystem
- 12: Systemkomponente
- 13: Netzteil
- 14: Lüfter
- 15: Mikrocontroller
- 16: Prozessor
- 17: Systemmanagementkomponente
- 21 - 24: Verfahrensschritte
- A - E: Graphen verschiedener Größen

## Patentansprüche

1. Verfahren zur Bestimmung eines Ersatzwerts einer primärseitigen Leistungsaufnahme eines Netzteils (13) umfassend die Schritte:
- wiederholtes Erfassen eines ersten Messwerts bezüglich einer primärseitigen Leistungsaufnahme über jeweils einen Messzeitraum (T₁);
- wiederholtes Erfassen eines zweiten Messwerts bezüglich wenigstens einer sekundärseitigen Ausgangsleistung in ersten zeitlichen Abständen (T₂), wobei der erste zeitliche Abstand (T₂) kleiner ist als der Messzeitraum (T₁);
- Ermitteln eines Wirkungsgrads des Netzteils (13) basierend auf dem ersten Messwert und wenigstens einem zweiten Messwert für jeweils einen Messzeitraum (T₁); und
- Errechnen eines Ersatzwerts für die primärseitige Leistungsaufnahme basierend auf dem im Schritt des Ermittelns ermittelten Wirkungsgrad und wenigstens einem erfassten zweiten Messwert.

2. Verfahren nach Anspruch 1, wobei das Ermitteln des Wirkungsgrads auf wenigstens einem ersten Mittelwert einer Mehrzahl zweiter, mit dem ersten Messwert zeitlich korrelierten Messwerten und dem ersten Messwert basiert.

3. Verfahren nach Anspruch 2, wobei für das Errechnen des Ersatzwerts für die primärseitige Leistungsaufnahme ein zweiter Mittelwert mehrerer erster Mittelwerte herangezogen wird, welcher über ein Vielfaches des Messzeitraums (T₁) gebildet wird.

4. Verfahren nach den Ansprüchen 1 bis 3, wobei der Schritt des Errechnens periodisch in zweiten zeitlichen Abständen (T₄) durchgeführt wird, wobei der zweite zeitliche Abstand (T₄) für das Errechnen eines Ersatzwerts für die primärseitige Leistungsaufnahme kleiner ist als der Messzeitraum (T₁).

5. Verfahren nach einem der Ansprüche 1 bis 4, **dadurch gekennzeichnet, dass** die Ermittlung des Wirkungsgrads auf wenigstens einer der nachfolgenden Größen beruht: primärseitige Eingangsspannung, Lüfterdrehzahl wenigstens eines Lüfters (14) und Lastbereich des Netzteils (13).

6. Computersystem (11) umfassend wenigstens ein Netzteil (13) und einen Mikrocontroller (15), wobei der Mikrocontroller (15) dazu eingerichtet ist, die Schritte eines Verfahrens gemäß einem der Ansprüche 1 bis 5 durchzuführen.

7. Computersystem (11) nach Anspruch 6, **dadurch gekennzeichnet, dass** der zur Ausführung des Verfahrens eingerichtete Mikrocontroller (15) in dem Netzteil (13) des Computersystems (11) angeordnet ist.

8. Computersystem (11) nach Anspruch 6, **gekennzeichnet durch** eine Systemmanagementkomponente (17), wobei der zur Ausführung des Verfahrens eingerichtete Mikrocontroller (15) Teil der Systemmanagementkomponente (17) ist.

9. Computersystem (11) nach Anspruch 6, **gekennzeichnet durch** einen Chipsatz, wobei der zur Ausführung des Verfahrens eingerichtete Mikrocontroller (15) Teil des Chipsatzes des Computersystems (11) ist.

10. Computerprogrammprodukt umfassend ausführbaren Programmcode, wobei beim Ausführen des ausführbaren Programmcodes durch eine Datenverarbeitungsvorrichtung eines Computersystems in Verbindung mit einem Netzteil ein Verfahren gemäß einem der Ansprüche 1 bis 5 ausgeführt wird.

## Claims

1. Method of determining a substitute value of a primary-side power consumption of a power supply unit (13), comprising the steps:
- repeated detecting of a first measuring value with respect to a primary-side power consumption over one measuring time period (T₁) respectively;
- repeated detecting of a second measuring value with respect to at least one secondary-side output power in first time intervals (T₂), wherein the first time interval (T₂) is smaller than the measuring time period (T₁);
- determining an efficiency of the power supply unit (13) based upon the first measuring value and at least one second measuring value for one measuring time period (T₁) respectively; and
- calculating a substitute value for the primary-side power consumption based upon the efficiency determined in the step of the determining, and at least one detected second measuring value.

2. Method according to claim 1, wherein the determining of the efficiency is based upon at least one first mean value of a plurality of second measuring values, temporally correlated with the first measuring value, and the first measuring value.

3. Method according to claim 2, wherein, a second mean value of multiple first mean values, which is formed over a multiple of the measuring time period (T₁), is used to calculate the substitute value of the primary-side power consumption.

4. Method according to claims 1 to 3, wherein the calculating step is carried out periodically at second time intervals (T₄), wherein the second time interval (T₄) for the calculating of a substitute value for the primary-side power consumption is smaller than the measuring time period (T₁).

5. Method according to one of claims 1 to 4, **characterized in that** the determining of the efficiency is based on at least one of the following variables: primary-side input voltage, fan speed of at least one fan (14), and load range of the power supply unit (13).

6. Computer system (11), including at least one power supply unit (13) and a microcontroller (15), wherein the microcontroller (15) is configured to carry out the steps of a method according to one of the claims 1 to 5.

7. Computer system (11) according to claim 6, **characterized in that** the microcontroller (15), configured to carry out the method, is arranged in the power supply unit (13) of the computer system (11).

8. Computer system (11) according to claim 6, **characterized by** a system management component (17), wherein the microcontroller (15), configured to carry out the method, is part of the system management component (17).

9. Computer system (11) according to claim 6, **characterized by** a chipset, wherein the microcontroller (15), configured to carry out the method, is part of the chipset of the computer system (11).

10. Computer program product including executable program code, wherein a method according to one of the claims 1 to 5 is carried out when executing the executable program code by a data-processing device of a computer system in connection with a power supply unit.

## Revendications

1. Procédé de détermination d'une valeur de substitution d'une consommation de puissance côté primaire d'un bloc d'alimentation (13), comprenant les étapes :
- détection à plusieurs reprises d'une première valeur de mesure relative à une consommation de puissance côté primaire pendant respectivement une période de mesure (T₁);
- détection à plusieurs reprises d'une seconde valeur de mesure relative à au moins une puissance de sortie au secondaire à des premiers intervalles temporels (T₂), le premier intervalle temporel (T₂) étant inférieur à la période de mesure (T₁) ;
- détermination d'un rendement du bloc d'alimentation (13) sur la base de la première valeur de mesure et d'au moins une deuxième valeur de mesure pour respectivement une période de mesure (T₁) ; et
- calcul d'une valeur de substitution pour la consommation de puissance côté primaire sur la base du rendement déterminé dans l'étape de détermination et d'au moins une deuxième valeur de mesure détectée.

2. Procédé selon la revendication 1, dans lequel la détermination du rendement se base sur au moins une première valeur moyenne d'une pluralité de secondes valeurs de mesure corrélées dans le temps avec la première valeur de mesure et sur la première valeur de mesure.

3. Procédé selon la revendication 2, dans lequel, pour le calcul de la valeur de substitution pour la consommation de puissance au côté primaire, une seconde valeur moyenne de plusieurs premières valeurs moyennes est prise en compte, qui est formée sur un multiple de la période de mesure (T₁).

4. Procédé selon les revendications 1 à 3, dans lequel l'étape du calcul est effectuée périodiquement à des seconds intervalles temporels (T₄), le second intervalle temporel (T₄) pour le calcul d'une valeur de substitution pour la consommation de puissance au côté primaire étant inférieur à la période de mesure (T₁).

5. Procédé selon l'une quelconque des revendications 1 à 4, **caractérisé en ce que** la détermination du rendement repose sur au moins un des paramètres suivants : la tension d'entrée au côté primaire, la vitesse de rotation de ventilateur d'au moins un ventilateur (14) et la plage de charge du bloc d'alimentation (13).

6. Système informatique (11) comprenant au moins un bloc d'alimentation (13) et un microcontrôleur (15), le microcontrôleur (15) étant conçu pour effectuer les étapes d'un procédé selon l'une quelconque des revendications 1 à 5.

7. Système informatique (11) selon la revendication 6, **caractérisé en ce que** le microcontrôleur (15) conçu pour exécuter le procédé est disposé dans le bloc d'alimentation (13) du système informatique (11).

8. Système informatique (11) selon la revendication 6, **caractérisé par** un composant de gestion de système (17), le microcontrôleur (15) conçu pour exécuter le procédé faisant partie du composant de gestion de système (17).

9. Système informatique (11) selon la revendication 6, **caractérisé par** un chipset, le microcontrôleur (15) conçu pour exécuter le procédé faisant partie du chipset du système informatique (11).

10. Produit programme informatique comprenant un code de programme exécutable, dans lequel, lors de l'exécution du code de programme exécutable par un dispositif de traitement de données d'un système informatique en liaison avec un bloc d'alimentation, un procédé selon l'une des revendications 1 à 5 est exécuté.
